# EUROPEAN PATENT APPLICATION

(11) **EP 1 690 626 A2**
(43) Date of publication of application: **16.08.2006**
(21) Application number: 06002757.0
(22) Date of filing: 10.02.2006
(51) Int. Cl.: B23K 15/00, B23K 15/02, B23K 15/06, H01J 37/304, G01T 1/29, G01R 19/00

(54) **Electron beam welding method and apparatus with a slit plate and measuring device for determining a location of the electron beam**

(30) Priority: 11.02.2005 US 652465 P
(71) Applicant: PTR Präzisionstechnik GmbH, 63477 Maintal (DE); Schubert, Guenther G., 63477 Maintal (DE); Delong, Steven D., 63477 Maintal (DE)
(72) Inventor: Schubert, Guenther G., Longmeadow, MA 01006 (US); Delong, Steven D., Enfield, CT 06082 (US)
(74) Representative: Kramer - Barske - Schmidtchen

(57) **Abstract**

An electron beam welding apparatus (100) includes an electron beam generator (104) for selectively emitting an electron beam (B) into a weld chamber (102). The electron beam welding apparatus (104) further includes a measuring device (108) for detecting an intensity of the electron beam (B) and a slit plate disposed between the electron beam generator (104) and the measuring device (108). The slit plate permits passage of the electron beam (B) through a slit formed in the slit plate, and the measuring device (108) determines a location of the electron beam (B) in dependence upon the detected intensity of the electron beam (B) passing through the slit. The electron beam welding device further includes thermally non-conductive and/or absorbing materials strategically placed between parts to be welded and all components of mechanical assemblies requiring precision location.

## Description

### CROSS REFERENCE TO RELATED APPLICATIONS

This application claims the benefit of U.S. Provisional Application Serial No. 60/652,465, filed on February 11, 2005, and herein incorporated by reference in its entirety.

### FIELD OF THE INVENTION

This invention relates in general to a method and apparatus for improved electron beam welding, and deals more particularly with a method and apparatus for improved electron beam welding that substantially eliminates the temperature distortion of tooling within the welding chamber while providing precise confirmation of the electron beam position.

### BACKGROUND OF THE INVENTION

Electron beam welding (EBW) is a fusion joining process that produces a weld by impinging a beam of high energy electrons upon a weld joint. The high energy electrons provide the necessary heat to fuse, or weld, two or more workpiece articles together along the weld joint.

Known EBW assemblies typically utilize measurement devices, like optical viewing systems, to determine the approximate location of the electron beam. Typically, Faraday Cups are known to be used for precisely measuring the electrical quality of the electron beam, but is not known to be used to identify the location of the generated electron beam.

Many high precision electron beam welds are performed in a weld chamber that enjoys some measure of a vacuum, most often a high vacuum. In practice, the workpiece to be welded is held (by means of, e.g., a collet or other fixing means) opposite the emission end of the electron beam generating device while the workpiece is mechanically moved beneath the beam, or the electron beam generator is moved above the workpiece, or the electron beam is deflected by electromagnetic means, or the like, or by some combination of the foregoing.

As is also known, one of the advantages of the electron beam welding process compared to any other fusion welding process is its flexibility, which is due to all welding parameters being electrical in nature, including the electron beam itself. Without any change of hardware, process parameters can be varied in a wide range simply by changing control settings. For instance, the process allows for dynamically deflecting and moving the electron beam in order to join two stationary pieces together. The electromagnetically deflected beam can be positioned on the joint with very high accuracies of less than 0.001 inches, which is comparable to the precision of mechanical means, but avoids any wear over time that is known to alter the precision of such mechanics.

EBW assemblies are therefore utilized in the manufacture of many high precision components. Economic and other production concerns have increased pressure to manufacture such components in a mass production environment, to which the EBW assemblies are initially well suited.

There are, however, several concerns related with the mass production of components via an EBW assembly that can potentially affect the accuracy of the EBW assembly as a whole. Chief amongst these concerns is the problem of thermal drift, or distortion, of those tooling surfaces exposed to the thermal radiation effects of the electron beam impingement device.

In particular, the heat generated by the electron beam conducts through the workpiece and thereby over time heats up all tooling within the weld chamber. The heat radiation coming from the hot weld also heats up all surrounding areas of the EBW assembly. Thus, the heat that is inherently generated via the operation of the EBW assembly during the mass production of components very often causes a displacement, drift or distortion of all tooling within the weld chamber. That is, the heat generated as a by-product of the EBW process can cause the movement of the collet or fixing method with respect to the emission end of the electron beam generator or affect the relative positioning of other tooling within the weld chamber. Over time, the amount of thermal displacement of the tooling can exceed that of the accuracy of the electromagnetic deflection system resulting in the beam to workpiece positioning accuracy being determined by the tooling.

As will be appreciated, the mass production of components, if done over and over again within the same weld chamber, and utilizing the same tooling, exacerbates the difficulties of thermal distortion or drift. Thus, there exists a need to address the thermal concerns of known EBW assemblies while providing positive measurement of the electron beam position relative to the tooling even though the tooling is drifting or distorting due to heat.

Over time, the amount of thermal displacement (e.g. within one production shift) of conventional tooling (stationary or moving) can be larger than the achievable accuracy of the beam positioning, meaning that the limiting factor for overall beam-to-joint accuracy lays within the mechanical design of the tooling. In such an environment where highest accuracies are required to satisfy the demanded specification, the tooling design has to consider heat sources and related thermal growth over time.

The demand for minimal thermal growth of the tooling over time (e.g. one shift) can be solved with a combination of active cooling and the use of materials with low thermal conductivity, which restricts the thermal flow coming from the part while welding. The present design allows the temperature to be balanced in the tooling assembly thus minimizing thermal growth over time and thereby maintaining the workpieces' positioning accuracy within allowable technical limits. In addition, a measuring tool has been designed and integrated into the system for the use as a control feature. It allows the machine operator to automatically determine the accuracy and stableness of beam deflection and tooling thermal displacement in production before each assembly gets welded.

With the forgoing problems and concerns in mind, it is the general objective of the present invention to provide a method and apparatus for improved electron beam welding that substantially reduces or eliminates the temperature distortion of tooling within the welding chamber and provides an accurate method of determining the position of the electron beam relative to the tooling.

### SUMMARY OF THE INVENTION

It is an object of the present invention to provide an improved electron beam welding assembly.

It is another aspect of the present invention to provide an improved electron beam welding assembly that has an increased ability to ameliorate the effects of thermal distortion or displacement of the tooling inside the weld chamber.

It is another aspect of the present invention to provide an improved electron beam welding assembly that includes a plurality of various insulating elements to protect differing areas from thermal radiation within the weld chamber.

It is another aspect of the present invention to provide an improved electron beam welding assembly that positions an insulating element between the beam generating device and the measuring tool.

It is another aspect of the present invention to provide an improved electron beam welding assembly that positions a plurality of insulating elements about the detection chamber and Faraday Cup assembly, thereby isolating the tooling and measuring device from thermal radiation from the Faraday Cup assembly within the weld chamber.

It is another aspect of the present invention to provide an improved electron beam welding assembly that provides cooling channels through the insulating plates in order to protect the tooling of the electron beam welding apparatus from thermal radiation.

It is another aspect of the present invention to provide an improved electron beam welding assembly that is capable of precisely, and repeatedly, detecting and adjusting the position of the electron beam.

It is another aspect of the present invention to provide an improved electron beam welding assembly that utilizes a slit plate in conjunction with a Faraday Cup assembly and control system to precisely, and repeatedly, detect and adjust the position of the electron beam.

It is another aspect of the present invention to provide an improved electron beam welding assembly that utilizes thermally non-conductive pins, or other contacts, in the workpiece holding fixture, thus protecting the workpiece holding fixture from the distorting effects of thermal conduction and radiation.

These and other objectives of the present invention, and their preferred embodiments, shall become clear by consideration of the specification, claims and drawings taken as a whole.

### BRIEF DESCRIPTION OF THE DRAWINGS

Figures 1 is a schematic illustration of an improved electron beam welding (EBW) assembly, in accordance with one embodiment of the present invention.

Figure 2 illustrates a top plan view of the beam position measuring tool of the improved EBW assembly.

Figure 3 illustrate section A-A, taken through the beam position measuring tool shown in Figure 2.

Figure 4 illustrate section B-B, taken through the beam position measuring tool shown in Figure 2.

Figure 5 illustrates a top plan view of the protective platen of the improved EBW assembly.

Figure 6 illustrates a side plan view of the protective platen of Figure 5.

Figure 7 illustrates a top plan view of an alignment cover for use with the protective platen of Figures 5 and 6.

Figure 8 illustrates a side plan view of an alignment cover for use with the protective platen of Figures 5 and 6.

Figure 9 illustrates a front plan view of an alignment cover for use with the protective platen of Figures 5 and 6.

Figure 10 illustrates a top plan view of a collet and insulating pins for use in holding the workpiece that is to be welded, in accordance with one embodiment of the present invention.

Figure 10A illustrates a side plan view of a collet, as shown in Figure 10.

Figure 10B illustrates a section through the collet, shown in Figure 10.

Figure 11 illustrates a top plan view of a collet and insulating pins for use in holding the workpiece that is to be welded, in accordance with another embodiment of the present invention.

Figure 11A illustrates a side plan view of a collet, as shown in Figure 11.

Figure 11B illustrates a section through the collet, shown in Figure 11.

Figure 12 illustrates a top plan view of a rotary assembly for moving the collet used with the present EBW assembly.

Figure 13 illustrates a side plan view of the rotary assembly shown in Figure 12.

Figure 14 illustrates a section (A-A) through the rotary assembly shown in Figure 13.

Figure 15 illustrates another section (B-B) through the rotary assembly shown in Figure 13.

Figure 16 illustrates a precision locating assembly for use with the EBW assembly, in accordance with one embodiment of the present invention.

Figure 17 shows a section taken through the precision locating assembly of Figure 16.

### DETAILED DESCRIPTION OF THE PREFERRED EMBODIMENT

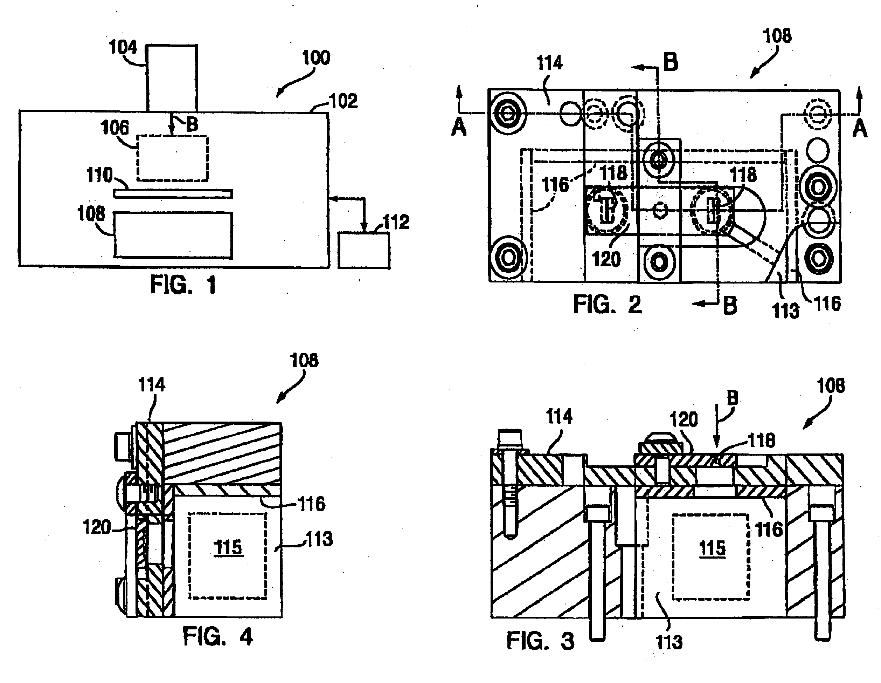

Figure 1 is a schematic illustration of an EBW assembly 100, in accordance with one embodiment of the present invention. As shown in Figure 1, a weld chamber 102 encloses a workpiece and fixturing assembly 106, a beam position measuring tool 108 and a protective platen 110. As will be appreciated, operation of the various components noted may be directed via an integrated control system 112. It will be readily appreciated that Figure 1 is a schematic representation only, and as such, does not represent specific structure or specific structural orientation with respect to the EBW assembly 100.

In contrast with known EBW assemblies, the beam position measuring tool 108 operates in conjunction with the control system 112 to not only initialize the EBW assembly 100 prior to its first use, but is also employed to help monitor and control the movement of the electron beam produced by the electron beam generator device 104. In this regard, the beam position measuring tool 108 provides feedback signals to the control system 112 so as to continually take into account the measured or detected position of the electron beam, thereby enabling precise control over the movement of the electron beam.

Figure 2 illustrates a top plan view of the beam position measuring tool 108, while Figures 3 and 4 illustrate sections A-A and B-B, respectively, taken through the beam position measuring tool 108 shown in Figure 2. It will be readily appreciate that, as illustrated in Figures 3 and 4, a known Faraday Cup assembly 115 (shown schematically) is housed within a detection chamber 113 created by a frame and top plate 114 and defined within the beam position measuring tool 108.

Referring to Figures 2-4 in combination, it will be seen that the beam position measuring tool 108 consists, in substantial part, of an overall frame having a top plate 114, a slit plate 120 and a plurality of insulating elements, or plates, 116. As best shown in Figure 2, an internal enclosure of ceramic plates 116 (shown in phantom), or other thermally insulating material, are disposed within the tool 108 so as to provide the frame and slit plate 120 some measure of thermal protection from the Faraday Cup assembly 115 housed within the detection chamber 113.

That is, during operation of the EBW assembly 100 the Faraday Cup assembly 115 will absorb and radiate increasing amounts of thermal radiation due to the incident electron beam B. It is therefore one important aspect of the present invention that the thermally insulating elements 116 are disposed adjacent to the Faraday Cup assembly 115 such that the elements 116 will protect the frame and slit plate 120, as well as the other components within the weld chamber 102_{;} from the effects of thermal radiation emanating from the Faraday Cup assembly 115.

Also illustrated in Figure 2 are two alignment slits 118 (although it will be readily appreciated that at least one, but any number, of alignment slits may alternatively be present) which are formed in the slit plate 120. The slit plate 120 is preferably formed as a tungsten plate (or the like), and the two alignment slits 118 are opened to the path of the electron beam, so as to assist in the calibration of the position of the electron beam.

The frame with top plate 114 is thermally and electrically connected to the same support structure as the fixturing assembly 106 to ensure thermal stability between these two devices, thereby minimizing any relative movement between them and ensuring a conductive path to ground for any electrons contacting the slit plate 120. Alternately, or in addition to, the frame with top plate 114 could include conduits or channels for active cooling.

As is typical of Faraday Cup installations, the Faraday Cup 115 is electrically isolated from the machine and an insulated wire is passed through the wall of the vacuum chamber 102 and connected to the machine control system 112. Any electrons from the electron beam B that impinge on an alignment slit 118 will pass through the slit and be captured by the Faraday Cup 115, with the results passed through to the control system 112 for analysis.

Unique to this application, the positioning of the slit 118 provides a precise reference of the location of the beam relative to the fixturing assembly 106, as follows: If the electron beam B is programmed to pass through slit 118, and it does as confirmed by the Faraday Cup 115 housed in chamber 113 and related electronics, the position of the electron beam B is precisely known and confirmed. If a significant number, or a predetermined percentage, of electrons are not detected by the Faraday Cup 115 as passing through the slit 118, the position of the programmed beam path is thereby known to be astray. Once detected as being astray, the altering of the beam path can be accomplished automatically or manually by the control system 112.

It is therefore an important aspect of the present invention that the beam position measuring tool 108 which incorporates a Faraday Cup assembly 115 is utilized to detect the position of the electron beam B. That is, as opposed to known electron beam welding devices which may utilize a Faraday Cup to determine the electrical quality of the emitted electron beam, the present invention advantageously makes use of the Faraday Cup assembly 115 integrated into the beam position measuring tool 108 to determine the quality, as well as the location/position, of the electron beam B, via the integrated use of the slit plate 120 in conjunction with the control system 112.

Thus, the present invention utilizes the detected intensity of the generated electron beam to actively monitor, and automatically or manually compensate for, any deviation of the position of the electron beam B, as caused by the thermal displacement of the tooling within the weld chamber 102.

Additionally, the slit plate 120 and its supporting frame with top plate 114 are thermally isolated from the Faraday Cup 115 as to minimize heat transfer from the Faraday Cup 115 to the support frame which would cause undesired thermal distortion of same resulting in a displacement of slit 118.

It is therefore another important aspect of the present invention to substantially reduce or eliminate the detrimental effects of thermal distortion/displacement of the frame and slit plate 120 and resulting distortion/displacement of the slit 118 by surrounding the detection chamber 113 (and Faraday Cup) with an enclosure of thermally insulating plates 116, which may be ceramic, or other insulating materials. These insulting elements 116, effectively isolate the frame and slit plate 120 from thermal radiation emitted by the Faraday Cup that may, over time, affect the precision of slit 118 position.

Returning now to Figure 1, in operation the electron beam generator device 104 emits a high energy electron beam B which is incident upon the workpiece. The heat radiation stemming from the welding process can often cause thermal distortion of the conductive portions of the EBW assembly 100, inclusive of the frame that connects all of the components within the EBW assembly 100 (i.e., 106, 108 and 110).

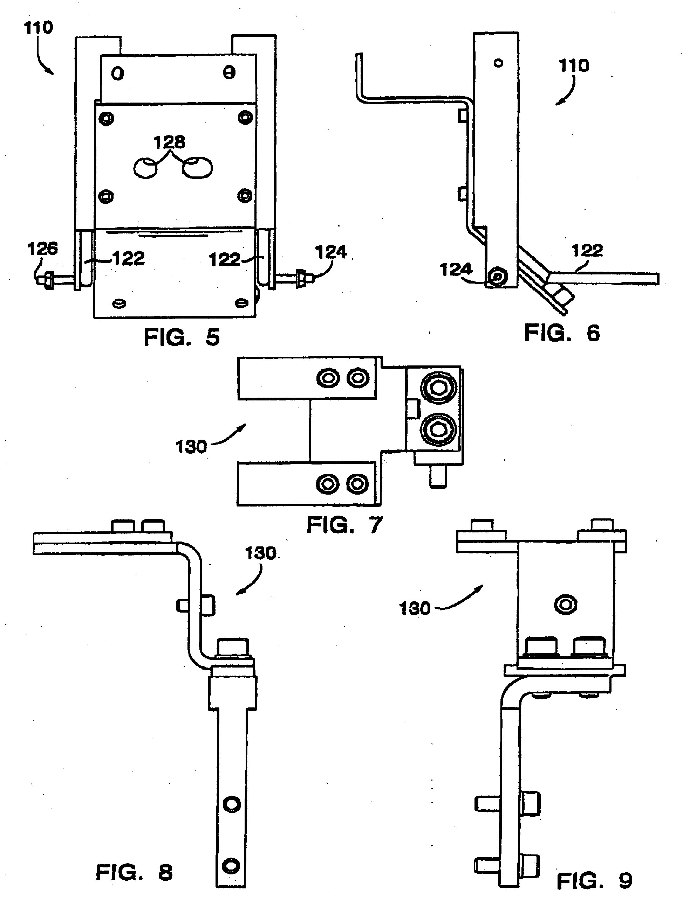

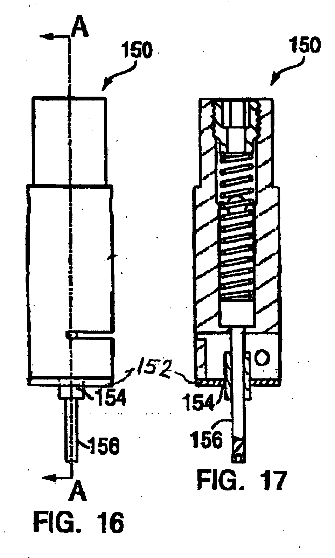

It is therefore an important aspect of the present invention that the EBW assembly 100 include devices that protect the frame, and the associated tooling, from such undesirable thermal radiation. These devices and methods include: 1) the protective platen 110 in the area between the workpiece and fixture assembly 106 and the beam position measuring tool 108 (shown in Figure 5, and to be discussed later); 2) thermal barriers between the Faraday Cup and the beam position measuring tool 108 (e.g., plates 116; described previously); 3) providing thermally conductive connections between the beam position measuring tool 108 and the system frame which also mounts the fixture assembly (as described previously); 4) an alignment cover 130 to protect the beam position measuring tool 108 from thermal radiation from the heated workpiece being welded; and 5) thermal barriers incorporated into the precision locating assembly (shown in Figures 16-17, and to be discussed later).

Turning now to Figures 5 and 6 which more clearly illustrate the protective platen 110. The protective platen 110 is envisioned to be formed from thermally non-conductive materials, such as but not limited to ceramics or the like. Moreover, the protective platen 110 may also be fashioned from a thermally conductive material, such as copper, provided that a cooling channel and/or conduit is formed therein to provide a cooling effect to the protective platen 110. It will be readily appreciated that the protective platen 110 may also be formed from a thermally non-conductive material equipped with cooling channels and/or conduits.

Figure 5 illustrates a top plan view of the protective platen 110. As discussed previously, the protective platen 110 includes one or more cooling channels and/or conduits 122 formed, molded or otherwise disposed therein. The cooling conduits 122 include an inlet aperture 124 and an outlet aperture 126 through which a supply of cooling fluid is passed. The cooling fluid may be any fluid capable of absorbing thermal energy, including but not limited to water, oil, liquefied nitrogen or the like. Figure 6 illustrates a side view of the protective platen 110.

It is therefore another important aspect of the present invention that by placing the thermally non-conductive protective platen 110 above the beam position measuring tool 108, the beam position measuring tool 108 is thereby protected from the most damaging effects of the thermal radiation produced during electron beam welding. Moreover, by optionally and selectively cooling the protective platen 110 with the cooling channels/conduits 122, the thermally insulating effects of the protective platen 110 may be further increased.

Returning to Figure 5, two alignment apertures 128 are formed in the protective platen 110 so as to selectively expose the alignment slits 118 in the beam position measuring tool 108 below. That is, an automated alignment cover 130 (shown in plan and side views, respectively, in Figures 7-9) is controlled via the control system 112 (or manually) to uncover the alignment apertures 128, thus permitting the electron beam to selectively enter through the alignment slits 118 and be detected by the beam position measuring tool 108, as discussed previously.

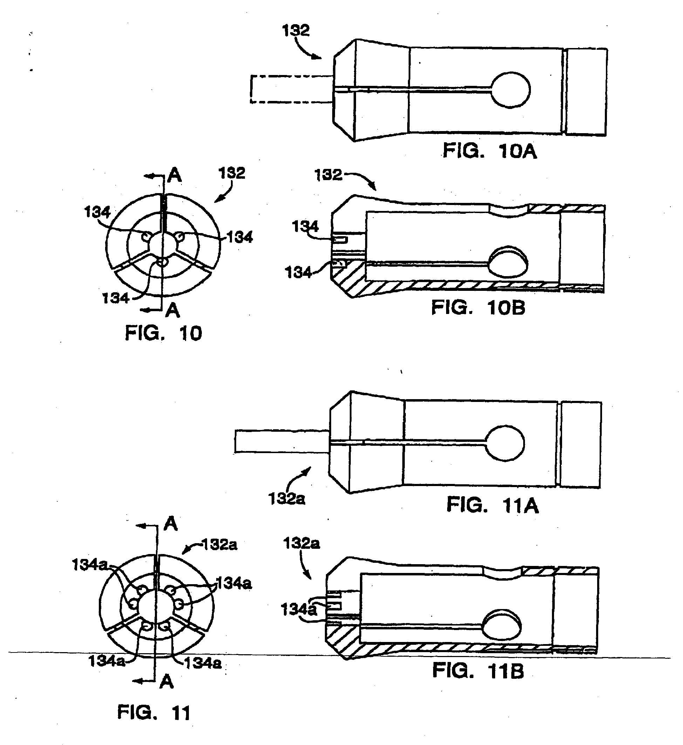

Figures 10 and 11 illustrate yet another important aspect of the present invention. As shown in Figure 10, a collet 132 is designed to selectively close about, and hold, the workpiece to be welded. A collet is shown by way of example, but it will be readily appreciated that any workpiece holding fixture would also be applicable to the concept of the present invention.

In order to assist in the thermal protection of the collet 132 itself, the present invention contemplates disposing a plurality of ceramic pins 134 (or other thermally isolating material appropriate for the workpiece holding function) about the inner periphery of the collet 132, thereby providing a thermally non-conductive interface between the heated workpiece and the body of the collet 132. The ceramic pieces can be loosely connected to the collet and provide high accuracy, or alternatively, they may be permanently bonded to the collet and grounded in place for the highest possible accuracy of the system. Figure 11 is much the same as Figure 10, however the collet 132a enjoys an array of six ceramic pins 134a disposed about the inner periphery of the collet 132a.

While Figures 10 and 11 illustrate a plurality of ceramic pins 134, the present invention is not so limited in this regard as the thermal barrier may alternatively be of any appropriate size or configuration. Figures 10A and 10B illustrate a side view and a section A-A, respectively, of the collet 132, while Figures 11A and 11B illustrate a side view and a section B-B, respectively, of the collet 132a.

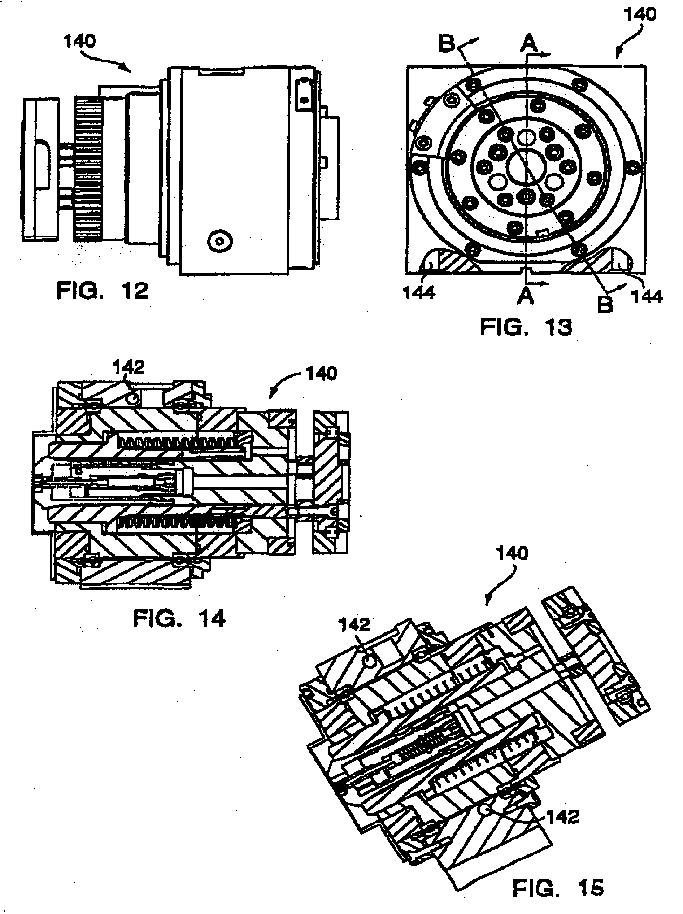

As discussed previously, the electron beam may be electromagnetically deflected (by a known process and apparatus) during the welding process. The electron beam generator 104 and/or the collet 132 (or other fixture) may also be rotated or otherwise shifted during welding so as to impart a spiral or curved weld to the workpiece. In this regard, Figure 12 illustrates a top plan view of a rotary assembly 140 for moving the collet 132. Figure 13 illustrates a front plan view of the rotary assembly 140, while Figures 14 and 15 shown sections A-A and B-B, respectively of the rotary assembly shown in Figure 13.

As best seen in Figures 13-15, the rotary assembly 140 includes one or more cooling channels/conduits 142 formed therein for providing the rotary assembly 140 with some measure of thermal stabilization during the welding process. Inlet and outlet distal ends, 144, are provided to supply the cooling channels/conduits 142 with a suitable cooling fluid, as discussed previously.

Figure 16 illustrates a precision locating assembly 150 for use with the EBW assembly 100, in accordance with one embodiment of the present invention. Figure 17 shows a section A-A taken through the precision locating assembly 150. As shown in Figures 16 and 17, the precision locating assembly 150 includes a ceramic plate or housing 152 within which is supported a spring biased pin 156. As will be appreciated, the spring biased pin includes a distal end which contacts the workpiece that is to be welded in the EBW 100. In this manner, the spring biased pin 156 provides the necessary electrical connection of the workpiece, upon which the electron beam B is incident, to ground.

In operation, the precision locating assembly 150 is pressed to the workpiece against the force of a biasing spring 153, whereby the pin 156 is caused to retract into the housing 152 until the workpiece substantially contacts an insulating collar or tube 154 disposed about the pin 156. While the pin 156 is preferably made from a conductive material so as to provide an exit path to ground for the electrons striking the workpiece, the housing 152 and the tube 154 are themselves formed from ceramic or other thermally insulating materials so as to isolate the precision locating assembly 150 from the thermal conduction of heat passing from the workpieces and through the pin 156.

It is therefore another important aspect of the present invention that the precision locating assembly 150 is also isolated and protected from undesirable thermal drift of its components, via the application of ceramic (or other materials having low thermal coefficients) thermal barriers, such as those that form the housing 152 and the tube 154. By ensuring that the components of the precision locating assembly 150 do not experience thermal drift during operation of the EBW assembly 100, the present invention substantially eliminates the erroneous positioning of the workpiece as it relates to the electron beam B.

As will be appreciated by consideration of the embodiments illustrated in Figures 1-17 that the present invention provides for the substantial elimination of thermal drift or distortion within the vital components of the EBW assembly 100 while repeatedly providing precise positioning of the joint to the electron beam. Moreover, by thermally insulating those vital components, the present invention enables the accurate and repeated mass production of workpieces welded in the weld chamber 102.

In another first aspect, a method for protecting tooling within a weld chamber of an electron beam welding assembly from thermal radiation and/or conduction resulting from a generated electron beam comprises the steps of:
orienting a measuring device within said weld chamber so as to detect an intensity of said electron beam;
disposing a fixturing assembly between said electron beam and said measuring device, said fixturing assembly holding a workpiece in a path of said electron beam;
disposing a protective platen between said fixturing assembly and said measuring device, said protective platen having an aperture to permit passage of said electron beam to said measuring device.

In another second aspect, a method for protecting a precision locating assembly as part of a tooling assembly within a weld chamber of an electron beam welding assembly from thermal radiation and/or conduction comprises the steps of:
arranging a fixturing assembly in said weld chamber for holding a workpiece in a path of said electron beam;
abutting a tip of said precision locating assembly against said workpiece, said tip extending outwardly from a housing of said precision locating assembly; and
thermally isolating said tip by disposing a thermal barrier between said tip and said housing.

In another second aspect, the method may further comprise the steps of:
disposing a measuring assembly beneath said fixturing assembly, said measuring assembly being capable of detecting said electron beam; and
interspacing a protective platen between said fixturing assembly and said measuring device, said protective platen having an aperture to permit passage of said electron beam to said measuring device.

In the another second aspect, the method may further comprise the steps of:
forming said measuring assembly to include a Faraday Cup assembly; and
placing a thermal enclosure about said Faraday Cup assembly, thereby isolating said welding chamber from heat emanating from said Faraday Cup assembly.

While the invention has been described with reference to the preferred embodiments, it will be understood by those skilled in the art that various obvious changes may be made, and equivalents may be substituted for elements thereof, without departing from the essential scope of the present invention. Therefore, it is intended that the invention not be limited to the particular embodiments disclosed, but that the invention includes all equivalent embodiments.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. An electron beam welding apparatus, comprising
an electron beam generator (104) for selectively emitting an electron beam (B) into a weld chamber (102),
a measuring device (108, 115) for detecting an intensity of said electron beam (B), and
a slit plate (120) disposed between said electron beam generator (104) and said measuring device (108, 115), said slit plate permitting passage of said electron beam through a slit (118) formed in said slit plate (120), wherein said measuring device (108, 115) determines a location of said electron beam (B) in dependence upon said detected intensity of said electron beam passing through said slit (108).

2. The electron beam welding apparatus according to claim 1, wherein
said slit plate is formed in a thermally conductive top plate, or
said slit plate is in contact with a thermally conductive top plate.

3. The electron beam welding apparatus according to claim 2, wherein
said thermally conductive top plate is attached to a thermally conductive frame.

4. The electron beam welding apparatus according to claim 2 or 3, wherein
said thermally conductive top plate includes a cooling channel formed therein.

5. The electron beam welding apparatus according to one of claims 1 to 4, further comprising
a protective platen (110) disposed between said electron beam generator and said slit plate, said protective platen having an aperture aligned with said slit.

6. An electron beam welding apparatus, comprising
an electron beam generator (104) for selectively emitting an electron beam into a weld chamber (102),
a fixturing assembly (106) for holding a workpiece relative to said electron beam (B),
a measuring device (108, 115) for detecting an intensity of said electron beam (B), and
a protective platen (110) disposed between said fixturing assembly (106) and said measuring device (108, 115), said protective platen having an aperture to permit passage of said electron beam to said measuring device.

7. The electron beam welding apparatus according to one of claims 6, wherein
said fixturing assembly (106) includes a collet for securing said workpiece, and
wherein said collet contacts said workpiece via a thermally non-conductive element, said thermally non-conductive element preferably being one of a ceramic collar and a plurality of ceramic pins.

8. The electron beam welding apparatus according to one of claims 1 to 7, wherein said measuring device is a Faraday Cup assembly (115).

9. The electron beam welding apparatus according to claim 8, wherein
said measuring device (108, 115) includes an insulating means disposed adjacent to said Faraday Cup assembly (115) for insulating said weld chamber from (102) heat emanating from said Faraday Cup assembly (115).

10. The electron beam welding apparatus according to claim 8 or 9, wherein
said measuring device includes thermally non-conductive elements defining an enclosure for said Faraday Cup assembly.

11. The electron beam welding apparatus according to one of claims 5 to 10, wherein
said protective platen (110) is thermally non-conductive.

12. The electron beam welding apparatus according to one of claims 5 to 11, wherein said protective platen (110) includes a cooling channel formed therein.

13. The electron beam welding apparatus according to claim 4 or 12, wherein
a fluid capable of absorbing thermal energy flows through said cooling channel.

14. A method for detecting the location of a generated electron beam within a welding chamber of an electron beam welding assembly, said electron beam welding assembly having an integrated control system, said method comprising the steps of:
orienting a measuring device within said welding chamber so as to detect an intensity of said electron beam;
disposing a slit plate between said electron beam and said measuring device, said slit plate defining a slit therein for permitting passage of said electron beam to said measuring device;
detecting an intensity of said electron beam passing through said slit and impinging upon said measuring device; and
utilizing said integrated control system to alter a position of said electron beam in dependence upon said detected intensity of said electron beam.

15. The method in accordance with claim 14, further comprising the step of employing a Faraday Cup assembly as said measuring device.

16. The method in accordance with claim 14 or 15, further comprising the steps of:
positioning a workpiece within said welding chamber to be incident to said electron beam; and
abutting said workpiece with a tip of a precision locating assembly.

17. The method in accordance with claim 16, further comprising the step of forming a thermal barrier about said tip, thereby thermally isolating said precision locating assembly from heat conducted through said tip.
